# EUROPEAN PATENT APPLICATION

(11) **EP 3 375 283 A1**
(43) Date of publication of application: **19.09.2018**
(21) Application number: 16836300.0
(22) Date of filing: 16.08.2016
(51) Int. Cl.: A01K 45/00

(54) **IMPROVEMENT TO OPERATING SYSTEM OF MODULE FOR LOCKING INJECTION DEVICES OF A SUBSYSTEM FOR APPLYING SUBSTANCES INTO FERTILE EGGS**

(30) Priority: 18.08.2015 BR 102015019880
(71) Applicant: CEVA SAÚDE ANIMAL LTDA., 13140-000 Santa Terezinha, Paulínia - SP (BR)
(72) Inventor: BASTOS, César Da Silva, 13020060 Campina/sp (BR)
(74) Representative: Cabinet Becker et Associés
(86) International application number: PCT/BR2016/050196
(87) International publication number: WO 2017/027949

(57) **Abstract**

An improvement to an operational system of a module for locking injection devices of a subsystem for applying substances into fertile eggs represents an inventive solution in the field of poultry farming, in particular in the field of poultry breeding and more specifically in the step of application of vaccines and/or nutrients into fertile eggs (Ov), wherein the locking submodule (m1) of the subsystem for applying substances into fertile eggs has a distinguishing concept, the locking and stabilising of each injection device (I) by at least three inflatable elements (12) mounted side by side in respective adjacent openings (11b), and a pressure recognition submodule (m5) is provided under operational optics to allow the management submodule (m2) to decide whether to start the substance inoculation module.

## Description

### TERMINOLOGY

Aiming at better understanding the subject matter disclosed and claimed in the present patent application, the meaning of some terms richly cited in the body of the descriptive report is shown, wherein:
- Egg-candling: is a procedure where it is checked whether the eggs are actually fertilized (fertile) and if they are not, they are removed from the process of raising chickens or the like;
- Avian species: its concept refers to poultry farming that is the breeding of poultry for food production, especially meat and eggs. Among the species raised in poultry, chicken stands out. On a much smaller scale, birds are also raised such as turkeys, ducks, geese, quails, and ostriches.
- PLC: Programmable Logic Controller is a specialized computer, based on a microprocessor that performs control functions through software developed by the user (each PLC has its own software); and
- HMI: Human Machine Interface.

### APPLICATION FIELD

The present invention patent with the title in epigraph and subject of description and claim in this application deals with an inventive solution with outstanding benefits in the segment of poultry, notably in the sector of poultry reproduction and more specifically in the stage of application of vaccines and or nutrients in fertile eggs by injection.

### BACKGROUND OF THE INVENTION

In view of the scope of application, the applicant, an expert in the area of creation and development of embryos for the creation of poultry species, after thorough studies of the entire classification procedure, vaccination and or nutrition and suckling, identified a list of emerging needs in the stage of vaccination and or nutrition:
- optimizing the productivity of fertile eggs vaccinated and or with nutritional supplement;
- ensuring the efficiency of the individual intra-egg inoculation procedure, which is directly related to the height of each egg in the niche of a tray;
- ensuring the operational reliability of the substance application module, notably the positioning matrix of the individualized height of each substance injector, sustaining its heights throughout the substance inoculation cycle;
- providing a significant reduction in the need for corrective maintenance of the height calibration device of substance injection devices, minimizing the productivity compromise of the equipment that is dictated a priori by a production planning and control (PPC) routine;
- reducing maintenance costs, whether corrective or predictive, making it faster without compromising quality and reliability.

### REQUIREMENTS OF THE INVENTION

In line with the demand of the invention, the applicant has idealized the "*improvement to operating system of module for locking injector devices of a subsystem for applying substances into fertile eggs*" provided with associated novelty of inventive activity, as it does not follow in an obvious or obvious way from other anticipated techniques by the state of the art, thus conferring advantages from the industrial, commercial and technical points of view.

In addition, the "invention" is provided with industrial applicability, being economically feasible and therefore taking into account the strictness of patentability requirements, notably as an invention patent, according to the provisions of articles 8 and 13 of the Law No. 9.279.

### BACKGROUND OF THE TECHNIQUE

In order to provide veracity, and to consolidate the explicit context in the topics of the introductory table, an explanation is shown on the state of the art for the conventional subsystems of vaccination inside fertile eggs, namely the locking module and stability of injection devices of substances, and, after a critical analysis of these, once evaluated by technicians with expertise in the subject of procedures and operation of inoculation of intra-egg substances, will be able to identify its limiting aspects, thus consolidating the identification of the previously cited demand.
a. Architecture of the macro system for breeding of poultry species: in tight synthesis, the selection, vaccination of fertile eggs and dispatch for incubation is performed by a non-integrated, that is, the poultry farmer can make use of all or only part of its operational modules, and by acculturation, the said conventional system is formed by the following operational functional subsystems which are briefly described in the following paragraphs.
   a.1 Identification subsystem of fertile eggs: by which in close understanding, the operation of selecting fertile eggs can be done with equipment of a manual or automated nature. As for equipment of manual nature, the selection operation is done with the aid of a table that emits light under the eggs and the operator visualizes those that allow greater passage of light classifying them as infertile eggs. In automated systems, there are sensors provided with emitter and receiver of the light that passes through the eggs. In both situations, a human-machine interface (HMI) management subsystem, or alternatively a hand-held equipment having only one table with a defined light-emitting source, this subsystem acting on the incubation tray, and identifying the niches provided as "fertile eggs" and "non-fertile eggs".
      In this way occurs the procedure of removal of the infertile eggs from the incubation tray, where this operation is carried out through a platform with suction cups, for example, and only the "fertile eggs" are kept in the incubation tray".
   a.2 Subsystem for the application of substances in fertile eggs: where vaccination and or nutrition are performed through injector devices provided with punches and needles for each egg housing niche defined in the incubation tray. From the operational point of view, once the incubation tray is positioned under the vaccination module, the injector matrix is activated, descending collectively and moving towards the corresponding niches of the incubator tray, where at that moment the computerized system releases the dose of vaccine (or nutrients) to the needles; and
   a.3 Incubation subsystem of fertile eggs: after vaccination of the fertile eggs contained in the incubator tray, these fertile eggs are transferred to a basket, said delivery basket, the transfer being carried out by means of a matrix of suction cups disposed in matrix form, which descend simultaneously, and then vacuum is applied both to the suction cups corresponding to the fertile eggs and to the empty housings. The fertile eggs accommodated in the incubator tray are "sucked" by the suction cups and, in vertical movement, are transferred to the breeder's basket.
b. The paradigm of the invention: After this brief introduction of the architecture on the selection system, vaccination of fertile eggs and incubation of fertile eggs, for the purpose of the present invention has chosen the subsystem of vaccination and or nutrition of fertile eggs.

Research in patent databases reveals vaccination subsystems as anticipated by the state of the art, where the following patent documents deserve attention:
- US patent document US no. 6,286,455, entitled "AUTOMATED IN EGG INJECTION APPARATUS", published on 11/09/2001, whose material reveals a subsystem of simultaneous application of multiple substances by injection applied to eggs originating preferably from the egg-candling stage.

This prior art document is cited only in the light of the prior knowledge of subsystems for the application of substances in fertile eggs which have long been known, and the most commonly applied substances are vaccines, and more recently, nutrient administration.

In a remissive way, the constructive concept of the subsystem for the application of substances to fertile eggs can be understood as being composed of an accommodation and transport device, notably a tray in which egg niches are defined in a matrix form, the tray is positioned immediately beneath the device with multiple injectors of substances, each positioned immediately above its respective egg accommodation niche.

Also, in a remissive way, each injector device has the function of providing access to the interior of the egg by means of a shell opening mechanism and an injection needle in the most varied configurations possible.

In turn, from the operational point of view, once the niche parity condition - injector device is established, the module for application of substances is actuated in such a way that all the injecting devices are activated simultaneously, causing activation of the eggshell perforation mechanisms, and subsequently the injection needle which is the substance delivery element inside the fertile egg.

It happens that the correct operation of the injector matrix depends on its correct positioning and stability in a certain Cartesian coordinate "Z", whereby for this purpose, an operational stability and locking module of the matrix of injecting devices work with two variables of control, namely:
- the positioning on the Cartesian axis Z, which depends on the size of the egg disposal in the corresponding niche of each device;
- the stability of the device at the position of defined Cartesian axis Z.

In order to establish this operational condition of adjustment and stability of the injection devices, operational modules developed for this purpose are known in the state of the art.

Once again, research in patent databases reveal that this technology, among numerous patent documents, it is pertinent to mention US Patent No. 7,958,843 B2 entitled "IN EGG INJECTION MACHINE WITH TRANSVERSELY MOVABLE EGG TRAY ASSEMBLY FOR MANUAL EGG TRANSFER AFTER INJECTION" which, in a remissive way among so many devices, reveals a device that allows the adjustment of the Cartesian position Z and the lock of each injector device, where its constructive concept can be observed in Fig.. 7, where (...) a plurality of injector devices is positioned and supported in their respective plurality of openings (337) as defined on a support plate (332) to which inflatable elements (212) are accommodated. In this way, the injector device's body is passing through the inflatable elements (212) which, once actuated by the PLC of the equipment, begin to embrace and fix these devices in the Cartesian position Z previously defined by the height of the corresponding egg niche of the egg tray.

Another document that reveals the fit and stability of the injection devices is the Brazilian patent document BR MU8401284 entitled "CONSTRUCTIVE PROVISION INTRODUCED INTO AN AUTOMATIC EGG VACCINATOR", where it reveals that (...) the injectors remain supported and guided by a platform (18) of conical holes, which allows the movement of the injectors in order to facilitate their settlement on the eggs to be vaccinated, where the injectors are fixed by means of compressed air bladders (16).

In a remissive way, the conventional module for operating locking and stability of injector devices on the vertical displacement structural platform of a functional egg inoculation sub-system can be described as being formed by the following operational modules:
- locking sub-module, formed by the platform which has a matrix of openings where the respective matrix of injector devices is mounted, whereby these openings inside the platform are arranged diagonally or orthogonally in relation to these openings as linear inflatable elements, which once inflated interfere with the internal area of the said openings;
- a management sub-module, formed by a PLC unit, which controls the sending of a signal to the control sub-module for releasing compressed air supply to the plurality of inflatable elements;
- a control and release sub-module for compressed air supply, in the form of a 3/2-way pneumatic valve;
- a safety sub-module, formed by a quick release valve, so that the system can rapidly depressurize when necessary.

In turn, from the operational point of view, this conventional system can be described by the PLC to send a signal to the pneumatic valve that releases the compressed air to the locking platform, from that moment the PLC counts a time for the system to pressurize and release the signal to activate the injectors.

c. Identification of problems: although the stability and locking modules of injectors disclosed in cited patent document US No. 7,958,843 B2 entitled "IN-EGG INJECTION MACHINE WITH TRANSVERSELY MOVABLE EGG TRAY ASSEMBLY FOR MANUAL EGG TRANSFER AFTER INJECTION" and BR MU8401284 entitled CONSTRUCTIVE PROVISION INTRODUCED IN AUTOMATIC VACCINATOR OF EGGS are effective in meeting their main objective, the careful observation by experts in the area of fertilization and development of poultry embryos reveals a problem considered as critical, which can be outlined by the occurrence of operational defects related to the locking and stabilization sub-module.

When a defect occurs in the locking and stabilization sub-module, the module for inoculation of substances continues to operate in its other functions, notably in drilling and injection operations; however, due to the positional instability caused by said defect, the substance begins to be incorrectly inoculated intra-egg, thereby compromising one or more inoculation cycles such as vaccination, for example, thus obtaining batches of poorly immunized and/or nourished fertile eggs.

In turn, once the failure of the locking and stabilization sub-module is established, it is also verified that the maintenance of the same is difficult to execute, given the constructive concept of inflatable elements that are mounted inside the vertical displacement platform, which means high dismantling time of the platform with corresponding increased machine downtime and also high labor costs for repair intervention.

### d. Cause for the identified problems:

Defects in the locking and stabilization sub-module with the constructive concepts described in advance by the state of the art are due to insufficient pressurizing of the inflatable elements that embrace and stabilize the injection devices, due to non-unusual leaks in the structure of these inflatable elements, and it is possible to list a list of causes for this to occur which deserves attention:
- its operation is dependent on the continuous and stable supply of compressed air so as to promote the activation of the inflatable elements and locking of the injectors.
- there is no control ensuring that the necessary pressure is constant for the correct operation of the inflatable elements, especially in the case where air leakage is detected by the elements. Failure to obtain sufficient pressure on the inflatable elements in order to obtain the clamping effect of the injector devices will result in a gap in the platform housings and, consequently, the injector device will move during the drilling leading to non-conformities such as cracking of the eggshell, deformation, and disuse of the injection needle and, further, death of the embryo by needle perforation of its vital organs.

Finally, referring to the problem of complexity of the maintenance activity, its cause is explained by the complexity of the constructive concept of this device that confers difficulty in disassembling the same.

### DESCRIPTION OF THE INVENTION

a. Objective: it is an object of the present invention to solve the causes of the problems previously listed in the topic of technology fundamentals of the art by presenting an improvement in operating system, of the injector device locking device of a subsystem of application of substances in fertile eggs, which adds value to the conventional subsystem, wherein a remissive way such improvement confers the following predicates:
- to control and define the measurement of the compressed air pressure applied to the inflatable elements;
- to adjust the injector devices operation only if the handling stability of the injector devices + [inflatable] handle elements couple is guaranteed, through the correct supply of compressed air;
- only if the injector devices are actuated after the stabilization of the pressure in a suitable range;
- to generate feedback to the parameter management system of "pressure level" parameter, allowing the control unit to block the operation in case of an identified defect, such as air leakage, for example; Facilitate the maintenance and consequently reduce the machine downtime.

### b. Distinctive feature

### b.1 Constructive concept:

The locking and stability module of the substance injector devices consists of:
- a sub-module for locking injector devices, which in turn is composed of a vertical displacement platform which is to be manufactured from a single part, which receives a plurality of standard openings, through which is passing the body of each substance injector device, wherein adjacent to each opening is defined an assembly of at least three adjacent openings, which purpose is to provide the assembly of inflatable elements.

All the inflatable elements are communicating with each other by means of communication tubes, through which the compressed air is supplied.
- Management sub-module, wherein the sending of the compressed air to the plurality of inflatable elements mounted on the vertical displacement platform is defined by a PLC controller.
- pressure recognition sub-module, wherein the pressure reading in the plurality of inflatable elements is defined by a pressure transmitter;
- safety sub-module, in order to provide a safe equipment operation a quick release valve is provided so that the system depressurizes quickly when necessary, emptying the cartridges or bladders as fast as possible to make the machine cycle fast and it can proceed to the next step;
- a control and release sub-module for compressed air, where the release of the supply of compressed air to the matrix of inflatable elements mounted on the platform of vertical displacement is carried out by a 3/2-way pneumatic valve;

b.2 Functional concept: the improved injector device lockout module operating system of a sub-system for applying substances to fertile eggs has operational logic by sending a signal via the operational management sub-module, in the form of a PLC command to a sub-module controlling the release of compressed air in the form of a 3/2-way valve, which in turn releases the compressed air to the vertical displacement platform where the injector devices of substances are mounted and stabilized, and in turn, a sub-module identifying the compressed air supply stability is provided in the inflatable element matrix, in the form of a pressure transmitter, or alternatively a flow meter, which in turn sends a return signal to the sub-module in the form of a PLC command where it waits for a certain level of pressure to be obtained to ensure that all injector devices are embraced by the inflatable elements, so that only this condition enables the operation of the plurality of devices injectors, thus ensuring its operational effectiveness.

### DESCRIPTION OF THE FIGURES

Complementing the present description in order to obtain a better understanding of the features of the present invention, and according to a preferred practical embodiment thereof, the attached description is accompanied by a set of drawings, wherein:
- Fig. 1 is an illustrative representation in perspective of the constructive concept of the fertilizing egg application module anticipated by the state of the art, with reference to Fig. 2 of U.S. Patent No. 6,286,455, showing the main component parts, notably the vertical movement platform where is located the improvement in operating system of the module for locking injecting devices of a sub-system for application of substances in fertile eggs;
- Fig. 2 is an illustrative representation in late view of the constructive concept of the module for adding substances to fertile eggs anticipated by the state of the art, with reference to Fig. 1 of the U.S. patent document No. 6,286,455, showing the main components parts, namely the vertical movement platform where the improvement of the operative system of locking modules of injector devices of a sub-system of application of substances in fertile eggs is located;
- Fig. 3a is an illustrative representation of the architecture of the conventional module for activation and locking of injector devices in the vertical movement platform of a sub-system of application of substances in fertile eggs, as anticipated by the state of the art;
- Fig. 3b is an illustrative representation of component parts of each operating sub-module from the conventional module for driving and locking injector devices on the vertical movement platform of a sub-system for application of substances in fertile eggs, as anticipated by the state of the art;
- Fig. 4a is an illustrative representation of the architecture of the improved drive and locking module of injector devices in the vertical movement platform of a subsystem of application of substances in fertile eggs, as anticipated by the state of the art;
- Fig. 4b is an illustrative representation of component parts of each sub-module of the improved module for actuating and locking injector devices on the vertical movement platform of a sub-system for applying substances in fertile eggs, as anticipated by the state of the art;
- Fig. 5a is an illustrative perspective view of the constructiveness of the locking device of the injector devices of the locking sub-module of the improved drive and locking module, showing its component parts;
- Fig. 5b is an illustrative representation in view of raising the constructiveness of the locking device of the injector devices of the locking sub-module of the improved drive and locking module, showing their component parts;
- Fig. 6a is an illustrative representation in view of the elevation of the constructiveness of the mounting platform part of the locking device of the injector devices, showing their component parts;
- Fig. 6b is an illustrative representation in elevation view of an enlarged detail of the mounting bracket part of the locking sub-module of the improved locking drive module, showing its constructiveness;
- Fig. 7a is an illustrative perspective view of the inflatable element part of the locking device of the locking sub-module of the improved drive and locking module, showing its external constructiveness;
- Fig. 7b is an illustrative side view of the inflatable element part of the locking device of the locking sub-module of the improved locking and drive module, showing its external constructiveness;
- Fig. 7c is an illustrative representation of longitudinal cross-sectional view of the inflatable element part of the locking device of the locking sub-module of the improved drive and locking module, evidencing its external constructiveness;
- Figs. 8a and 8b are enlarged detail representations of elevation and perspective views of the locking device of the locking sub-module of the improved actuation and locking module, in a condition immediately prior to the activation of system pressurization; and
- Figs. 9a and 9b are enlarged detail representations of elevation and perspective views of the locking device of the locking sub-module of the improved actuation and locking module, in a condition immediately prior to system activation.

### DETAILED DESCRIPTION

The following detailed description should be read and interpreted with reference to the drawings shown and are not intended to limit the scope of the invention, but only limited to this explained in the claims.

### a. State of the art:

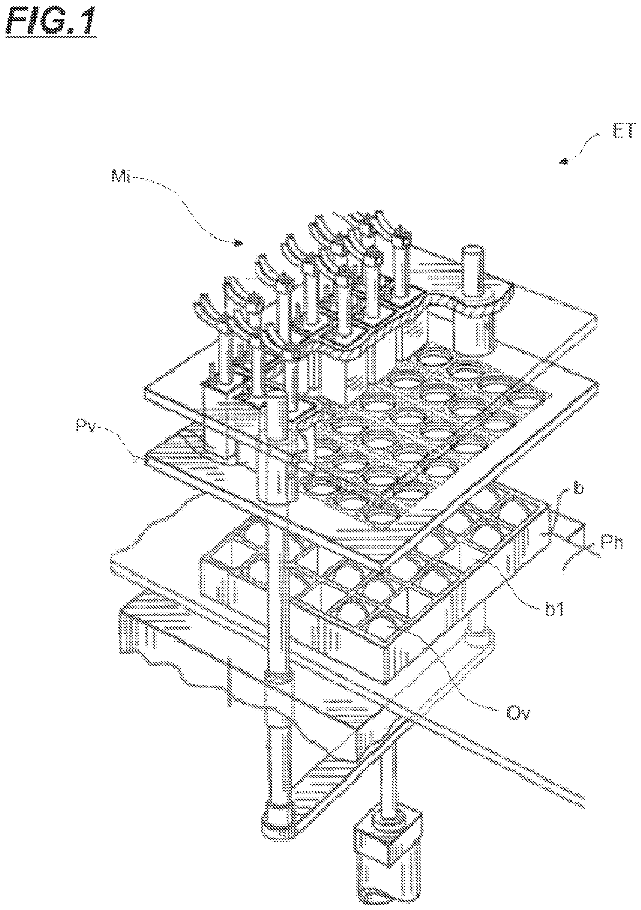

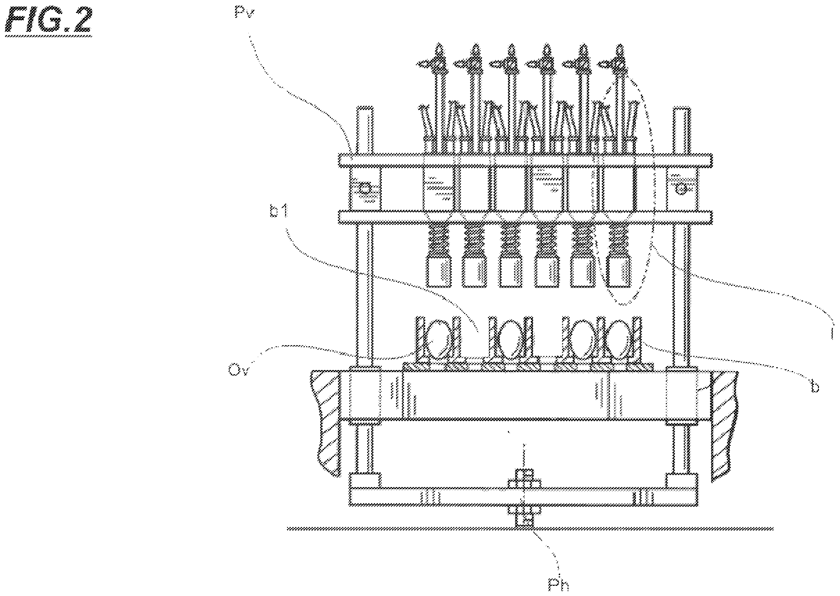

a.1 Understanding the field of application: as shown in Figs. 1 and 2, the conventional application subsystem of substances in fertile eggs (Et) is composed essentially of the devices:
- displacement module of the egg tray: formed by a horizontal displacement platform (Ph) which has the function of providing the displacement and positioning of the tray (b), and aligned with the matrix of injector devices (d);
- egg accommodating module: in the form of a tray (b), provided with a plurality of niches (b1) where the fertile eggs are accommodated (Ov);
- injector locking and stability module: in the form of a vertical displacement platform (Pv) which has the function of providing the assembly and stabilization of the injector matrix (I), also providing the vertical displacement of such matrix;
- injection module: in the form of a plurality of injector devices (I) for the purpose of providing an injection of substances, notably vaccines and nutrients;

As previously defined, the locking and displacement module of conventional injectors were chosen as the development paradigm.

### a.2 Technological basis

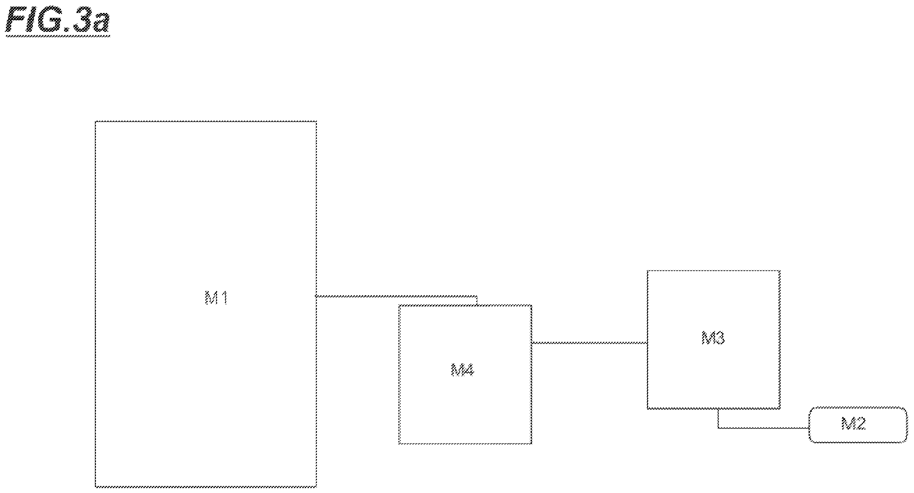

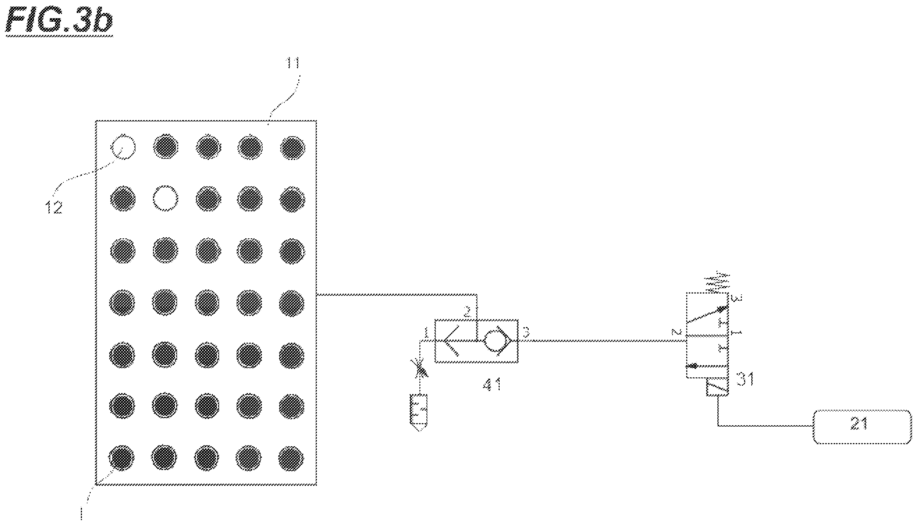

As shown in Figs. 3a and 3b, the locking and displacement module of conventional injectors shown in a remissive form displays the following architecture of operating sub-modules:
- a locking sub-module (m1), formed by the platform (11) having a matrix of openings (12) wherein the respective matrix of injector devices (I) is mounted, wherein to these openings (12), a set of linear inflatable elements within the platform is disposed diagonally or orthogonally to these openings, which once inflated interfere with the internal area of said openings (12);
- a management sub-module (m2), formed by a PLC unit (21), which controls the sending of the signal to the control and release of compressed air sub-module (m3) to the plurality of inflatable elements;
- a control and release of compressed air sub-module (m3), in the form of a 3/2-way air valve (31); and
- a safety sub-module (m4), formed by a quick release valve (41), so that the system will rapidly depressurize when necessary.

### b. Introduced improvements

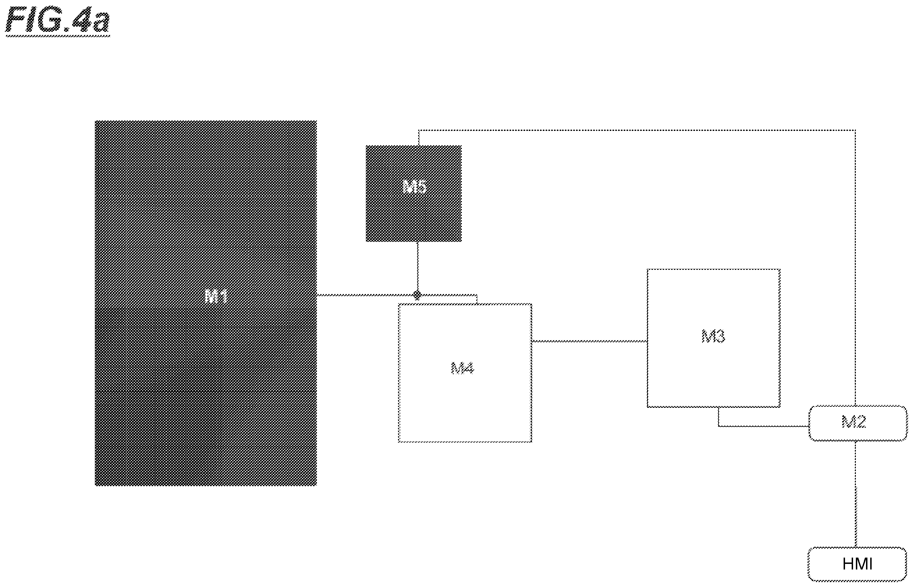

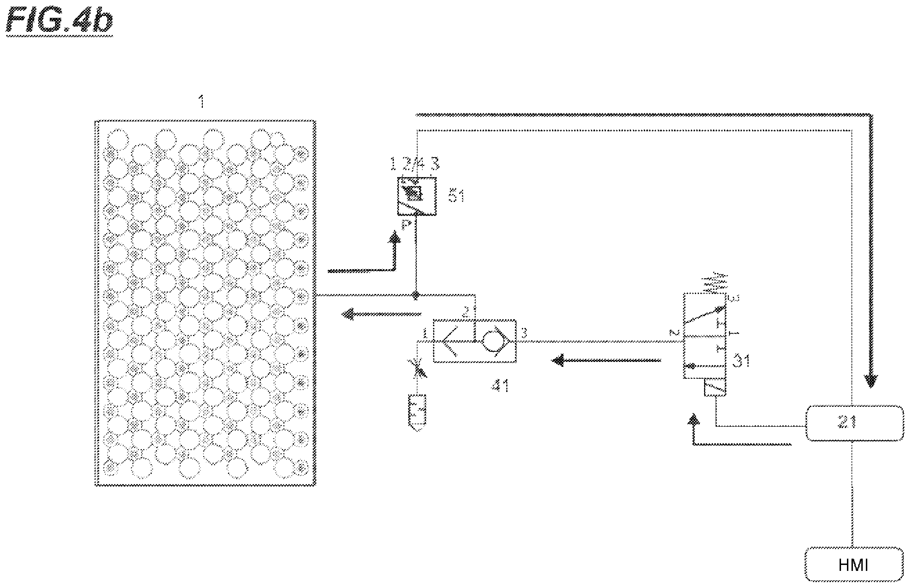

b.1 Operating system Improvement: As shown in Figs. 4a and 4b, the improved locking and displacement module of injectors shows, in a remissive manner, the measured architecture of sub-modules of the conventional module, by adding a sub-module identifying the compressed air supply stability (m5), which can be done by reading the pressure in the plurality of inflatable elements (12), wherein this case it is defined by a pressure transmitter (51).

Alternatively, the sub-module identifying the compressed air supply stability (m5) may be specified by performing the reading of the compressed air flow in the circuit, wherein this case it is defined by an air flow meter (52).

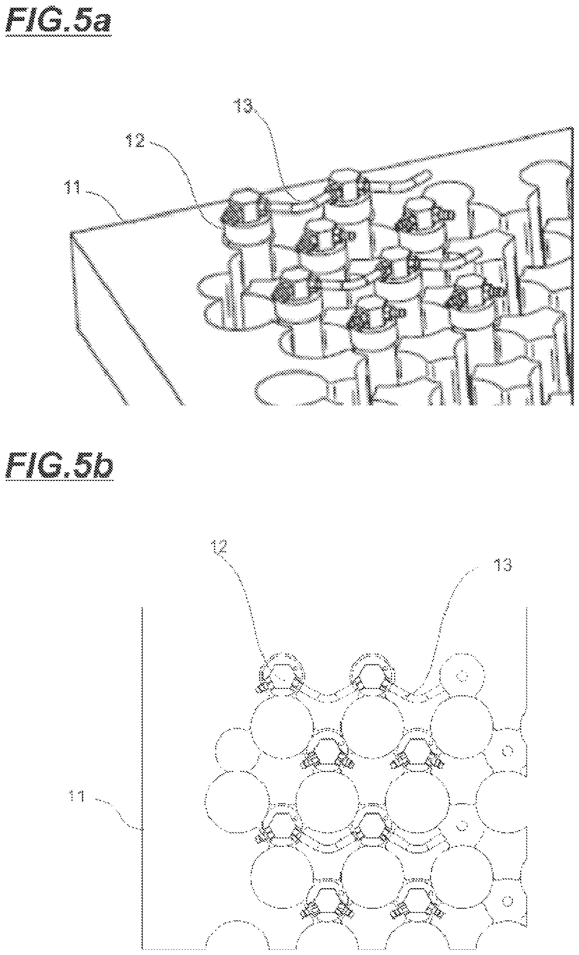

b.2 Improvement of the locking sub-module (m1): as shown in Figs. 5a and 5b, it is composed of: a platform (11) onto which a plurality of inflatable elements (12) is mounted which in turn are connected by segments of connector tubes (13) to configure a closed loop system.

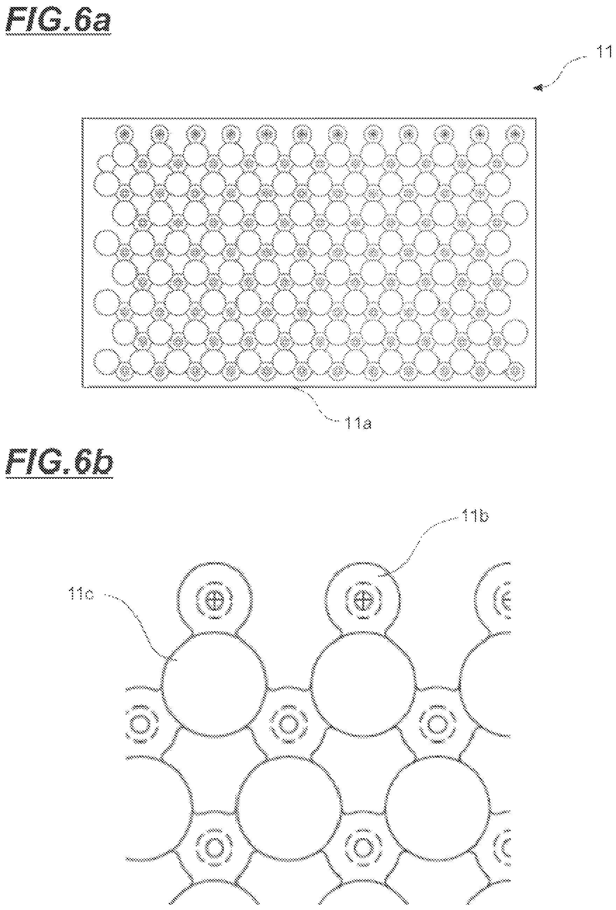

b.21 Platform (11): which detail is shown in Figs. 6a and 6b, composed of a single body (11a) receiving a plurality of standard openings (11c) through which the body of each substance injector device (I) passes and, adjacent to each opening (11c), a set of at least three adjacent openings (11b) is defined, which has the function of providing the assembly of inflatable elements (12);

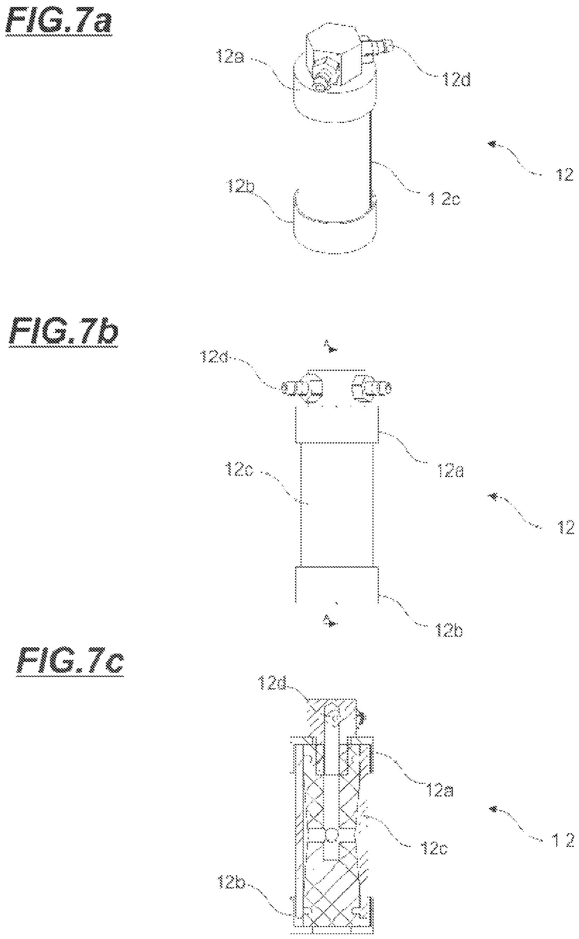

b.22 Inflatable elements (12): as shown in Figs. 7a, 7b and 7c respectively, wherein in a form of embodiment is defined a flexible tubular body (12c) whose upper and lower ends receive covers (12b) and (12a) respectively, the latter of which receives connecting terminals (12d) with the function of assembling where segments of connector tubes (13) are attached.

In turn, the inflatable elements (12) are mounted in the respective adjacent openings (11b) defined in the platform (11).

b.23 Connector tubes (13): all the inflatable elements (12) are communicating with each other by means of connector tubes (13), through which compressed air is supplied.

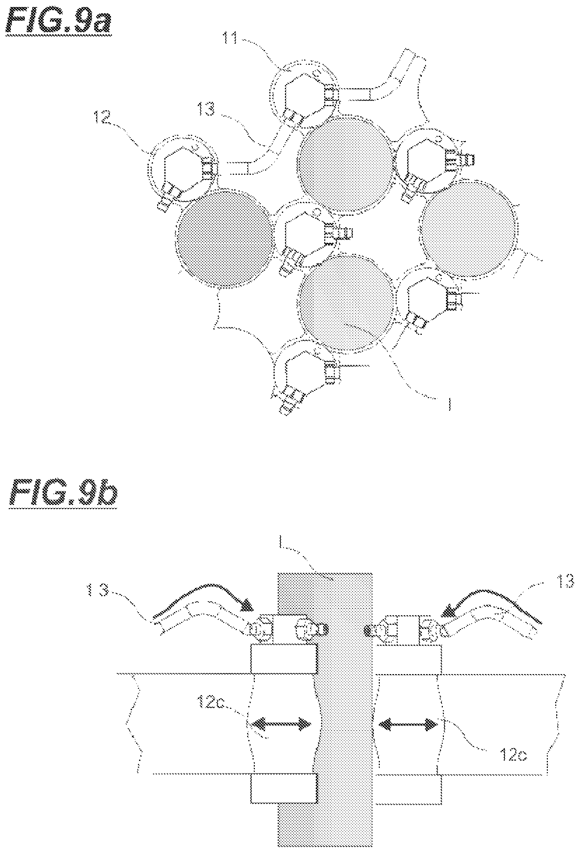

c. Operating logics: By means of a PLC command (21) of the operational management sub-module (m2) a signal is sent to the 3/2-way valve (31) of the control and release of compressed air sub-module (m3) which in turn releases the compressed air in a constant and stabilized way through the connector tubes (13), which fill the plurality of inflatable elements (12), creating internal pressure leading to the expansion of the flexible tubular body (12c), which in turn starts to compress the body of the injector device (I), promoting its locking and stability, as shown in Figs. 9a and 9b.

Once the condition for locking and stability of the injector device (I) is obtained, the internal pressure of the system formed by the plurality of connector elements (12) is measured by the pressure transmitter (51) of the pressure recognition sub-module (m5), which sends the data obtained, in a signal form, to the PLC command (21) of the operational management sub-module (m2), which in turn, makes the comparative parity of that value with a predetermined pressure value (or a range of values) previously defined at the time the operating system of the locking and displacement module of injectors was calibrated. If the measured pressure value is lower than the previously measured standard value, the PLC command (21) of the operational management sub-module (m2) truncates the operational initiation of the substance inoculation module, thus avoiding erroneous vaccination and/or nutrition procedures previously described in the topic of principles of the technique.

If the pressure value measured by the pressure transmitter (51) of the pressure recognition sub-module (m5) is equal to or greater than the specified value, the PLC command (21) of the operational management sub-module (m2) initiates the operation of the substance inoculation module.

### d. The obtained technical effect:

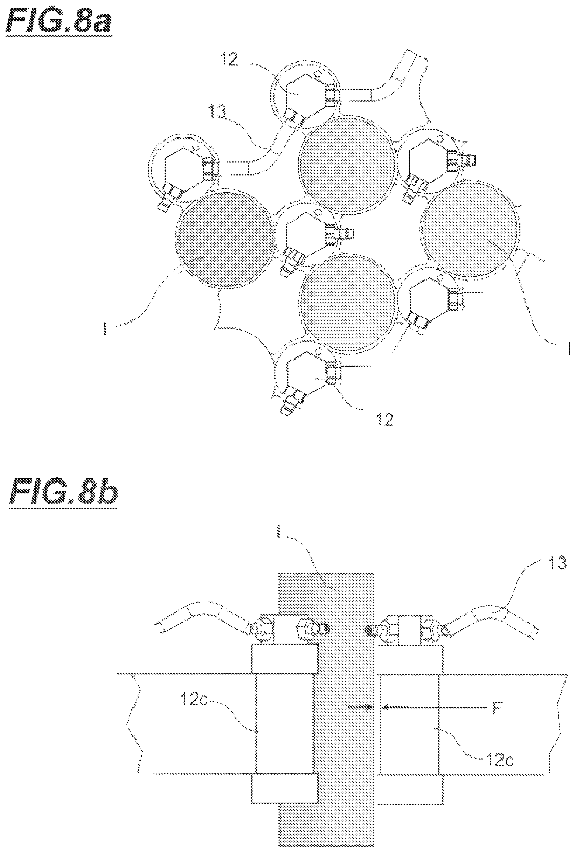

d.1 Locking and stabilization guarantee: as shown in Figs. 8a and 8b in an accommodating condition of the injector devices (I) in their respective standard openings (11c) further showing the assembly of the inflatable elements (12), showing that there is a gap (F) in a condition immediately prior to receiving compressed air by these inflatable elements (12).

In turn, once the locking and stability module of the injectors is activated, the technical effect is revealed through Figs. 9a and 9b, where it is visible the expansion of the walls of the flexible tubular body (12c), configuring the locking of the injectors (I), which guarantees the operational integrity of the subsystem of application of substances in fertile eggs.

d.2 Ease of maintenance of the locking sub-module: in the case of perforation of any one of the inflatable elements (12), the exchange operation of the same is easy to perform, by locating those non-conforming elements, disconnecting the ends of the connector tubes (13), withdraw them from the adjacent openings (11b) which support them in the body (11a) of the platform (11), and then replace them with a functional inflatable element (12).

The choice of the preferred embodiment of the subject invention in this carton, described in this detailing topic, is provided by way of example only. Changes, modifications, and variations can be made to any other embodiment of the operating system with the introduction of a pressure recognition sub-module (m5), and the improvement of the locking module (m1) of the subsystem for the application of substances to fertile eggs, whereby such changes may be designed by those skilled in the art, however, without departing from the disclosed object in the present patent application, which is defined exclusively by the appended claims.

It is seen from what has been described and illustrated that the "IMPROVEMENT TO OPERATING SYSTEM OF MODULE FOR LOCKING INJECTOR DEVICES OF A SUBSYSTEM FOR APPLYING SUBSTANCES INTO FERTILE EGGS" herein claimed conforms to the norms governing the patent of invention in light of the Industrial Property Law, deserving of what was exposed and as a consequence, the respective privilege.

## Claims

1. Improvement to operating system of module for locking injector devices of a subsystem for applying substances into fertile eggs, wherein a locking and displacement module of injectors is formed by a locking sub-module (m1), formed by a platform (11a) having a matrix of openings (11c), wherein the respective matrix of injector devices (I) is mounted, inflatable elements (12) being provided; a management sub-module (m2), formed by a PLC unit (21), a control and release sub-module for compressed air supply (m3), in the form of a 3/2-way pneumatic valve (31) and a safety sub-module (m4), formed by a quick release valve (41), wherein the improvement is **characterized in that** the locking sub-module (m1) has its platform (11) composed of a single body (11a) whose plurality of standard openings (11c) is defined as an assembly of at least three adjacent openings (11b), to which inflatable elements (12) are mounted composed of a flexible tubular body (12c) whose upper and lower ends receive covers (12b) and (12a) respectively, the latter of which receives connector terminals (12d) with the function of assembling where segments of connector tubes (13) are attached, all of the inflatable elements (12) being communicating with each other by means of these connector tubes (13), through which compressed air is supplied and a sub-module identifying the compressed air supply stability (m5) is further introduced in the form of a pressure transmitter (51).

2. Improvement to operating system of module for locking injector devices of a subsystem for applying substances into fertile eggs according to claim 1, wherein alternatively the sub-module identifying the compressed air supply stability (m5) is **characterized in that** it is an air flow meter (52).

3. Improvement to operating system of module for locking injector devices of a subsystem for applying substances into fertile eggs, whose operational process is initiated the PLC command (21) of the operational management sub-module (m2) sending a signal to the 3/2-way valve (31) of the control and release of compressed air sub-module (m3), which in turn releases the compressed air in a constant and stabilized way through the connector tubes (13), which fill the plurality of inflatable elements (12), creating internal pressure leading to the expansion of the flexible tubular body (12c), which in turn starts to compress the body of the injector device (I), promoting its locking and stability, and once this condition is obtained is **characterized in that** the internal pressure of the system formed by the plurality of connector elements (12) is measured by the pressure transmitter (51) of the pressure recognition sub-module (m5), which sends the data obtained, in a signal form, to the PLC command (21) of the operational management sub-module (m2), which in turn, makes the comparative parity of that value with a predetermined pressure value (or a range of values) previously defined at the time the operating system of the locking and displacement module of injectors was calibrated; if the measured pressure value is lower than the previously measured standard value, the PLC command (21) of the operational management sub-module (m2) truncates the operational initiation of the substance inoculation module, and if this measured value is equal to the specified value, the PLC command (21) of the operational management sub-module (m2) initiates the operation of the substance inoculation module.
